(19) Europäisches Patentamt
European Patent Office
Office européen des brevets

(11) **EP 2 985 709 A1**

(12) **EUROPEAN PATENT APPLICATION**
published in accordance with Art. 153(4) EPC

(43) Date of publication:
**17.02.2016 Bulletin 2016/07**

(21) Application number: **14782534.3**

(22) Date of filing: **07.04.2014**

(51) Int Cl.:
**G06F 17/50** (2006.01)    **G06Q 50/04** (2012.01)

(86) International application number:
**PCT/JP2014/060059**

(87) International publication number:
**WO 2014/168106 (16.10.2014 Gazette 2014/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.04.2013 JP 2013082900**

(71) Applicants:
• **Nissan Motor Co., Ltd**
  **Yokohama-shi, Kanagawa 221-0023 (JP)**
• **Imis Incorporated Company**
  **Tokyo 169-0051 (JP)**

(72) Inventors:
• **MIYOSHI, Hiroyasu**
  **Atsugi-shi**
  **Kanagawa 243-0123 (JP)**

• **IWASHITA, Kazufumi**
  **Atsugi-shi**
  **Kanagawa 243-0123 (JP)**
• **OGAWA, Yukio**
  **Atsugi-shi**
  **Kanagawa 243-0123 (JP)**
• **PARK, YoungWon**
  **Tokyo 169-0051 (JP)**
• **ABE, Takeshi**
  **Tokyo 169-0051 (JP)**

(74) Representative: **Osha Liang**
**2, rue de la Paix**
**75002 Paris (FR)**

(54) **DESIGN ASSISTANCE DEVICE AND DESIGN ASSISTANCE METHOD**

(57)    Provided is a design assistance device that can allow designers to easily figure out an efficient order of considering design items. The design assistance device includes: structure item determination means (11) for determining structure items related to a design object; performance item determination means (12) for determining performance items related to the structure items; performance-structure map creation means (13) for creating a performance-structure map in which correlations between the determined structure items and the determined performance items are shown in a matrix; and flow map creation means (14) for creating a flow map by rearranging each of an order of the structure items and an order of the performance items in the performance-structure map based on the correlations between the structure items and the performance items.

FIG. 1

**Description**

TECHNICAL FIELD

The present invention relates to a design assistance device and a design assistance method.

BACKGROUND ART

The designs of the drivetrain and the like of a vehicle are complicated since adjustment is required between different types of performance and between structures (components). For this reason, if the order of considering the design items is not appropriate at the time of determining specifications, one must go back to a previous phase or redo the whole process. As a result, the man-hours increase and the time is wasted. Hence, it is important to appropriately determine the order of considering the design items.

Design process management systems in which the concept of product architecture is introduced have heretofore been known for product development processes (see Patent Literature 1).

CITATION LIST

Patent Literature 1: Japanese Patent Application Publication No. 2006-11962

SUMMARY OF INVENTION

However, depending on the product, the number of design items for which specifications should be determined is significantly large and it is sometimes difficult to appropriately determine in what order the design items can be considered efficiently. This results in a problem in that one starts considering the design items in an inefficient order and has to go back to a previous phase or redo the whole process.

In view of the above problem, an object of the present invention is to provide a design assistance device and a design assistance method that can allow designers to easily figure out an efficient order of considering design items.

A design assistance device according to an aspect of the present invention includes: structure item determination means for determining structure items related to a design object; performance item determination means for determining performance items related to the structure items; performance-structure map creation means for creating a performance-structure map in which correlations between the determined structure items and the determined performance items are shown in a matrix; and flow map creation means for creating a flow map by rearranging each of an order of the structure items and an order of the performance items in the performance-structure map based on the correlations between the structure items and the performance items.

A design assistance method according to another aspect of the present invention includes the steps of: determining structure items related to a design object; determining performance items related to the structure items; creating a performance-structure map in which correlations between the determined structure items and the determined performance items are shown in a matrix; and creating a flow map by rearranging each of an order of the structure items and an order of the performance items in the performance-structure map based on the correlations between the structure items and the performance items.

BRIEF DESCRIPTION OF DRAWINGS

[Fig. 1] Fig. 1 is a block diagram showing an example of a design assistance device according to a first embodiment of the present invention.

[Fig. 2] Fig. 2 is a schematic diagram showing an example of a performance-structure map according to the first embodiment of the present invention.

[Fig. 3] Fig. 3 is a schematic diagram showing another example of the performance-structure map according to the first embodiment of the present invention.

[Fig. 4] Fig. 4 is a schematic diagram showing an example of a flow map according to the first embodiment of the present invention.

[Fig. 5] Fig. 5 is a flowchart for explaining an example of a design assistance method according to the first embodiment of the present invention.

[Fig. 6] Fig. 6 is a flowchart for explaining an example of a procedure to determined performance items according to the first embodiment of the present invention.

[Fig. 7] Fig. 7 is a block diagram showing an example of a design assistance device according to a second embodiment of the present invention.

[Fig. 8] Fig. 8(a) is a schematic diagram for explaining an example of a method of calculating the degree of influence of a structure item alone according to the second embodiment of the present invention, and of Fig. 8(b) is a schematic diagram for explaining an example of a method of calculating the degree of influence between structure items according to the second embodiment of the present invention.

[Fig. 9] Fig. 9 is a schematic diagram showing an example of a portfolio according to the second embodiment of the present invention.

[Fig. 10] Fig. 10 is a flowchart for explaining an example of a design assistance method according to the second embodiment of the present invention.

[Fig. 11] Fig. 11 is a schematic diagram showing an example of a performance-structure map according to a third embodiment of the present invention.

[Fig. 12] Fig. 12 is a schematic diagram for explaining an example of a method of calculating the degree of influence of a structure item alone and the degree of influence between structure items according to the third embodiment of the present invention.

[Fig. 13] Fig. 13 is a schematic view showing an example of a flow map according to the third embodiment of the present invention.

[Fig. 14] Fig. 14 is a schematic view showing an example of a flow map according to another embodiment of the present invention.

[Fig. 15] Fig. 15 is a schematic view showing another example of the flow map according to the other embodiment.

DESCRIPTION OF EMBODIMENTS

Embodiments of the present invention will now be described with reference to the drawings. In the following illustration of the drawings, the same or similar portions are denoted by the same or similar reference signs. Note that the drawings are schematic. Moreover, the embodiments to be described below are intended to exemplarily illustrate devices and methods for embodying the technical idea of this invention, and the technical idea of this invention can be changed in various ways within the scope of claims.

Meanwhile, the design of the drivetrain (DT) system of a vehicle will be mainly described as an example of a design to which design assistance devices and design assistance methods according to the embodiments of the present invention are applied. The DT system is a system configured to transmit power produced by an engine to wheels and is formed by a differential gear, a drive shaft, a transfer case, a transmission, and the like.

[First Embodiment]

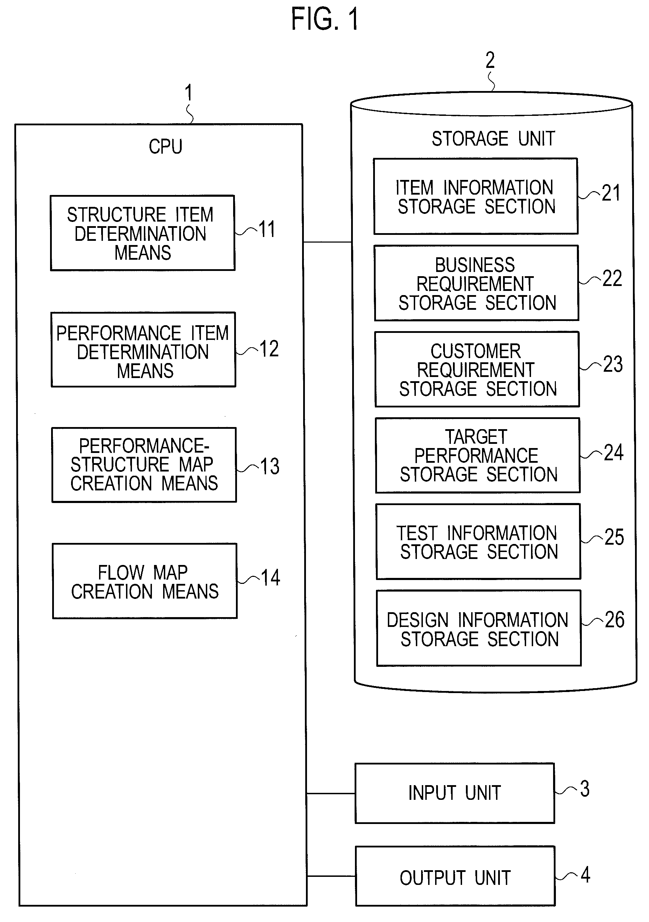

As shown in Fig. 1, a design assistance device according to a first embodiment of the present invention includes a central processing unit (CPU) 1, a storage unit 2, an input unit 3, and an output unit 4.

The CPU 1 is configured to perform various types of arithmetic processing by executing programs stored in the storage unit 2. The CPU 1 includes structure item determination means 11, performance item determination means 12, performance-structure map creation means 13, and flow map creation means 14.

As the storage unit 2, a semiconductor memory, a magnetic disk, an optical disk, or the like is usable. The storage unit 2 includes an item information storage section 21, a business requirement storage section 22, a customer requirement storage section 23, a target performance storage section 24, a test information storage section 25, and a design information storage section 26.

As the input unit 3, a keyboard, a mouse, a touchscreen, a microphone, or the like is usable, for example. As the output unit 4, a liquid crystal display, a CRT display, a printer, or the like is usable.

The structure item determination means 11 is configured to determine structure items for which specifications should be considered for the design object, based on item information stored in the item information storage section 21. For instance, for the DT system, the item information may include the platform model, the suspension model, the engine model, and the like. The structure items may include the vehicle mass, the engine maximum torque, the transmission model, the transfer case model, the transmission gear ratios, the drive shaft joint size, the differential gear size, the propeller shaft size, and the like.

The performance item determination means 12 is configured to determine performance items related to the structure items determined by the structure item determination means 11. For example, for the DT system, the performance item determination means 12 acquires requirements described in a standard work procedure manual and business requirements related to the vehicle such as the destination of the vehicle, the category of the vehicle, the planned number of vehicles to be produced and sold, the cost, and the amount of investment from the business requirement storage section 22. Further, the performance item determination means 12 extracts customers' demands for the vehicle (customer requirements) such as enjoyment of driving, mileage, reliability, and quietness from the customer requirement storage section 23.

Further, the performance item determination means 12 extracts performance requirements for the powertrain (PT) system and DT system that satisfy the business requirements and the customer requirements, based on target performance information stored in the target performance storage section 24 and test information stored in the test information storage section 25. The target performance information includes a list or the like in which target performance is quantified. The test information includes test evaluation items prescribed within the company, analysis items based on failure mode and effects analysis (FEMA). The PT system is formed as a system including the DT system plus the engine.

The performance requirements for the PT system and the DT system may include, for example, driving performance, fuel economy, robustness, and noise for the enjoyment of driving, mileage, reliability, and quietness, respectively, which are customer requirements. Also, the cost of the DT system or the like may be included for the amount of investment which is a business requirement. The performance item determination means 12 determines performance items for which specifications should be determined to satisfy the extracted performance requirements for the PT system and DT system. The performance items may include acceleration performance, mode related to fuel economy, robustness in collision, and gear performance for the driving performance, fuel economy, robustness, and noise, respectively, which are performance requirements for the PT system and the DT system.

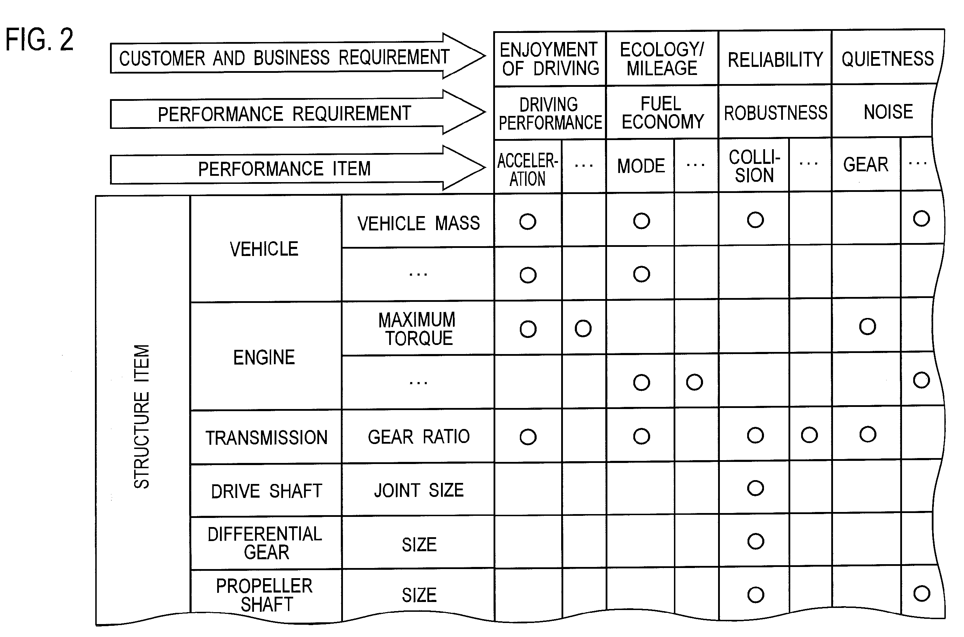

As shown in Fig. 2, the performance-structure map creation means 13 is configured to create a quality function deployment (QFD) matrix (hereinafter, also referred to as "performance-structure map") in which the correlations between the structure items determined by the structure item determination means 11 and the performance items determined by the performance item determination means 12 are shown in a matrix fashion.

In the performance-structure map shown in Fig. 2, the structure items are arranged along the column direction and the performance items are arranged along the raw direction. However, the positions of the structure items and the performance item may be switched. Moreover, the order of the structure items and the order of the performance items can be set as appropriate. Further, the number of structure items and the number of performance items are not particularly limited. Furthermore, structure items and performance items can be added or deleted based on an instruction inputted through the input unit 3 as well.

The performance-structure map creation means 13 is also configured to determine the presence or absence of a correlation between each structure item and each performance item based on design information, information on the vehicle of the previous model stored in the design information storage section 26. The performance-structure map creation means 13 is further configured to display the presence or absence of a correlation between each structure item and each performance item at the intersection of the structure item and the performance item.

In the performance-structure map shown in Fig. 2, the presence of a correlation is displayed as "○" while the absence of a correlation is displayed as a blank space. Note that the marks that indicate the presence or absence of a correlation are not particularly limited. Also, as will be described later, instead of displaying only the presence or absence of a correlation between a structure item and a performance item, the strength of the correlation (degree of contribution) may also be displayed using multiple types of marks.

Moreover, the presence or absence of a correlation between a structure item and a performance item and its strength (degree of contribution) may be determined based on instructions inputted through the input unit 3. The performance-structure map is, for example, stored in the storage unit 2 and displayed on a display part of the output unit 4.

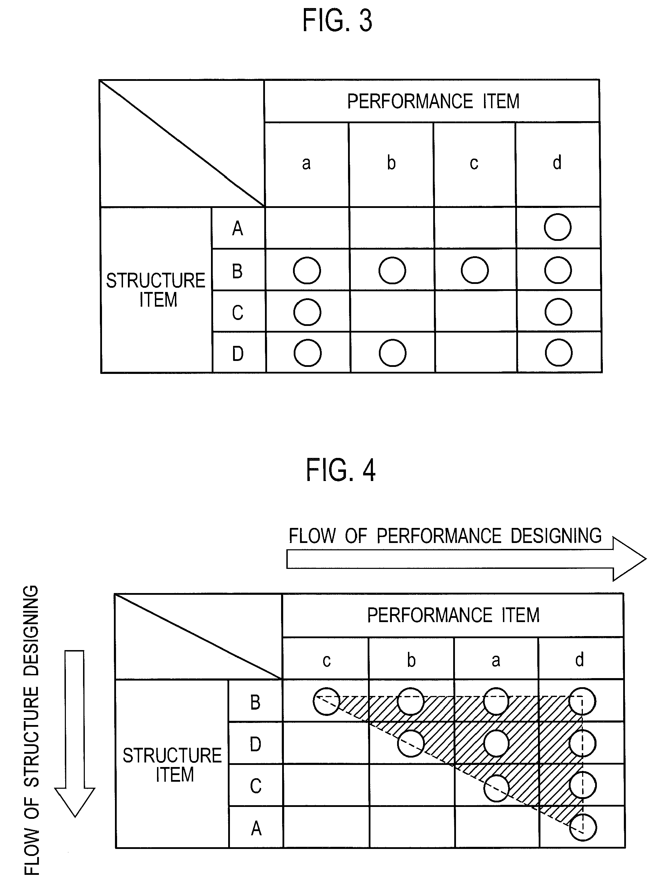

In the following, a performance-structure map in which the correlations between four structure items A, B, C, and D and four performance items a, b, c, and d are shown in a matrix, as shown in Fig. 3, will be described as an example for the sake of explanation.

The flow map creation means 14 shown in Fig. 1 is configured to create a flow map by rearranging the structure items and the performance items in the performance-structure map based on the correlations between the structure items and the performance items. The structure items and the performance items can be rearranged by using various types of calculation formulas can be used in accordance with the purpose and use.

Here, consider a case of obtaining the solution of a set of simultaneous equations (1), where $a_{ij}$ ($i,j = 1, \dots , m$) and $y_i$ ($i = 1, \dots , m$) are constants and $x_i$ ($i = 1, \dots , m$) is an unknown.

[Formula 1]

$$\begin{pmatrix} y_1 \\ y_2 \\ y_3 \\ \cdot \\ y_m \end{pmatrix} = \begin{pmatrix} a_{11} & a_{12} & a_{13} & \cdot & a_{1m} \\ a_{21} & a_{22} & a_{23} & \cdot & a_{2m} \\ a_{31} & a_{32} & a_{33} & \cdot & a_{3m} \\ \cdot & \cdot & \cdot & \cdot & \cdot \\ a_{m1} & a_{m2} & a_{m3} & \cdot & a_{mm} \end{pmatrix} \cdot \begin{pmatrix} x_1 \\ x_2 \\ x_3 \\ \cdot \\ x_m \end{pmatrix} \quad \dots (1)$$

To solve the formula (1), first, a coefficient matrix A is converted into a triangular matrix as shown in a formula (2) by using Gaussian elimination or the like. Then, the formula (1) is solved sequentially for the unknowns $x_m$, $x_{m-1}$, ... , and $x_1$ in this order. In this way, the amount of calculation can be reduced as a whole.
[Formula 2]

$$\begin{pmatrix} y_1 \\ y_2 \\ y_3 \\ \cdot \\ y_m \end{pmatrix} = \begin{pmatrix} a_{11} & a_{12} & a_{13} & \cdot & a_{1m} \\ 0 & a_{22} & a_{23} & \cdot & a_{2m} \\ 0 & 0 & a_{33} & \cdot & a_{3m} \\ \cdot & \cdot & \cdot & \cdot & \cdot \\ 0 & 0 & 0 & \cdot & a_{mm} \end{pmatrix} \cdot \begin{pmatrix} x_1 \\ x_2 \\ x_3 \\ \cdot \\ x_m \end{pmatrix} \quad \dots (2)$$

Then, as shown in Fig. 4, the flow map creation means 14 rearranges the order of the structure items in the performance-structure map to B, D, C, and A from top to bottom in descending order of the number of correlations present between the structure item and the performance items (in other words, in ascending order of the number of correlations from bottom to top), and rearranges the order of the performance items in the performance-structure map to c, b, a, and d from left to right in ascending order of the number of correlations present between the structure items and the performance item (in other words, in descending order of the number of correlations from right to left).

Here, if there are items with the same number of correlations present between the structure item and the performance items or vice versa, these items may be arranged in any order or the order may be determined as appropriate in accordance with the purpose or the like. As a result of the above rearrangement, the intersections of the correlated structure items and performance items are gathered on the upper right side and form a substantially right triangle (illustrated with hatched lines) equivalent to the triangular matrix.

Note that, while the right triangle is filled densely with "○" marks in Fig. 4, the shape does not necessarily have to be a rigid right triangle depending on how the manufacturing items and the performance items are correlated with each other. For example, "○" marks may be absent at some intersections situated inside the right triangle or on each side of the right triangle, and "○" marks may be shown at intersections outside the hypotenuse.

In the flow map in Fig. 4, as shown by arrows, the order of the structure items is determined as B, D, C, and A from top to bottom and, for each of these structure items, the order of the performance items is determined as c, b, a, and d from left to right. In this way, the design items can be considered effectively.

The flow map created by the flow map creation means 14 is, for example, stored in the storage unit 2 and displayed on the display part of the output unit 4.

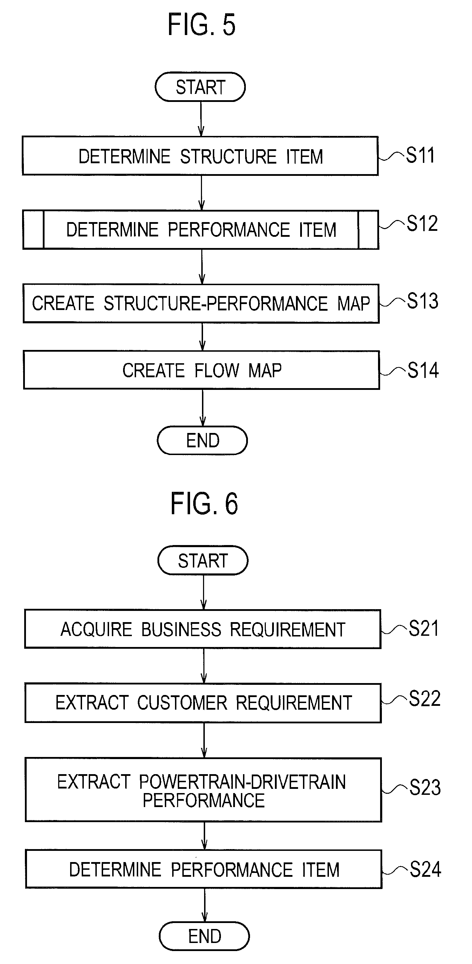

Next, an example of a design assistance method according to the first embodiment of the present invention will be described with reference to a flowchart in Fig. 5.

(A) In step S11, the structure item determination means 11 determines the structure items for which specifications should be determined, based on the item information stored in the item information storage section 21.

(B) In step S12, the performance item determination means 12 determines the performance items related to the structure items determined by the structure item determination means 11.

(C) In step S13, the performance-structure map creation means 13 creates a performance-structure map in which the correlations between the structure items determined by the structure item determination means 11 and the performance items determined by the performance item determination means 12 are shown in a matrix.

(D) In step S14, the flow map creation means 14 creates a flow map by rearranging each of the order of the structure items and the order of the performance items in the performance-structure map based on the correlations between the structure items and the performance items.

Next, an example of the procedure to determine the performance items in step S12 in Fig. 5 will be described with reference to a flowchart in Fig. 6.

(A) In step S21, the performance item determination means 12 acquires the business requirements for the vehicle, which employs the DT system, from the business requirement storage section 22.

(B) In step S22, the performance item determination means 12 extracts the customer requirements for the vehicle, which employs the DT system, from the customer requirement storage section 23.

(C) In step S23, the performance item determination means 12 extracts the performance of the PT system and DT system that satisfies the business requirements and the customer requirements, based on the target performance information stored in the target performance storage section 24 and the test information stored in the test information storage section 25.

(D) In step S24, the performance item determination means 12 determines the performance items based on the performance of the PT system and the DT system thus extracted.

According to the first embodiment of the present invention, the flow map is created automatically and logically by rearranging each of the order of the structure items and the order of the performance items in the performance-structure map based on the correlations between the structure items and the performance items. By presenting this flow map to the designers, the designers can easily figure out the efficient order of consideration that reduces the possibility of going back to a previous phase. Moreover, by having the designers consider the design items in the order of consideration provided by the flow map, differences in terms of the order of consideration between the designers are eliminated, and the consideration can therefore be advanced uniformly. Hence, the efficiency of the work can be improved.

Also, the flow map creation means 14 rearranges the structure items in the performance-structure map in descending or ascending order of the number of correlations present between the structure item and the performance items and rearranges the performance items in the performance-structure map in descending or ascending order of the number of correlations present between the structure items and the performance item. In this way, the designers can easily figure out the efficient order of consideration that reduces the possibility of going back to a previous phase.

[Second Embodiment]

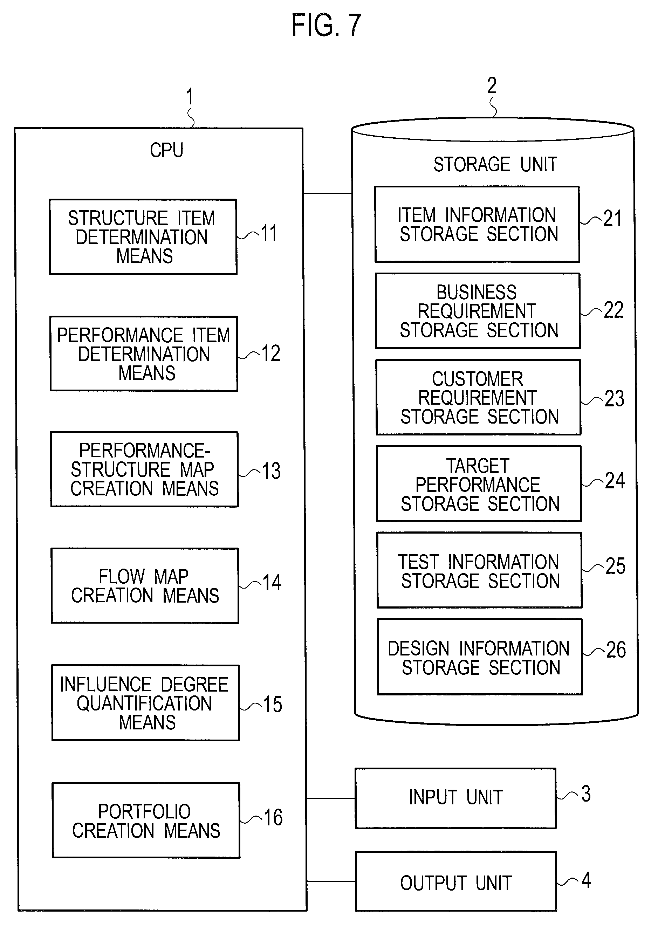

As shown in Fig. 7, a design assistance device according to a second embodiment of the present invention differs from the configuration shown in Fig. 1 in that the CPU 1 further includes influence degree quantification means 15 and portfolio creation means 16.

The influence degree quantification means 15 is configured to, for each structure item, quantify degrees influence of the structure item on all the design items (also referred to as "degree of complexity") based on the correlations between the structure items and the performance items in the performance-structure map created by the performance-structure map creation means 13. The degrees of influence of the structure item include the degree of influence of the structure item alone on the performance items and the degree of influence between the structure items.

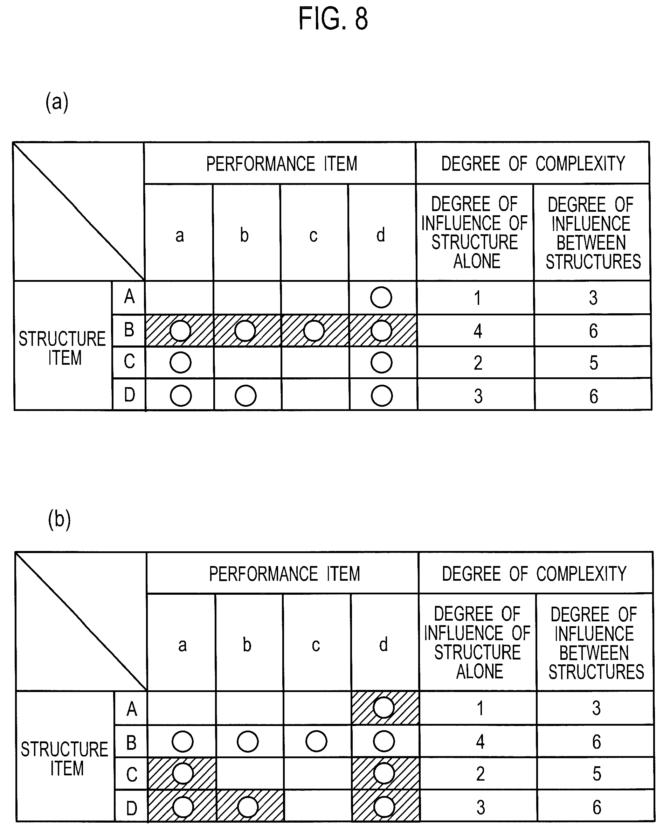

Among these, the degree of influence of the structure item alone is, in one example, a value obtained by adding up the number of correlations of the structure item in the raw direction. For example, as shown in part (a) of Fig. 8, for a structure item B, the influence of the structure item alone is quantified as "4" as a result of adding up the number of "○" marks shown with hatched lines. Like the structure item B, the influence of the structure item alone is quantified as "1," "2," and "3" for structure items A, C, and D, respectively.

On the other hand, the degree of influence between the structure items is, in one example, quantified by adding up the number of different structure items than the structure item of interest that are correlated with common performance items. For example, as shown in part (b) of Fig. 8, for the structure item B, the degree of influence between the structure items is quantified as "6" as a result of adding up the number of different structure items that are correlated with a common performance item a, namely, the structure items C and D, the number of different structure items that are correlated with a common performance item b, namely, the structure item D, and the number of different structure items that are correlated with a common performance item d, namely, the structure items A, B, and C, all of which are shown with hatched lines. Like the structure item B, the degree of influence between the structure items is quantified as "3," "5," and "6" for the structure items A, C, and D, respectively.

Note that the method of calculating the degree of influence of the structure item alone and between the structure items may not be simple addition. Various other calculation formulas are available for the quantification. For example, the correlations may be weighted based on the design information stored in the design information storage section 26, information inputted through the input unit 3, or the like, and then added up. Alternatively, the correlations may be given scores and multiplied. Also, mutually different calculation methods may be used for the degree of influence of the structure item alone and the degree of influence between the structure items.

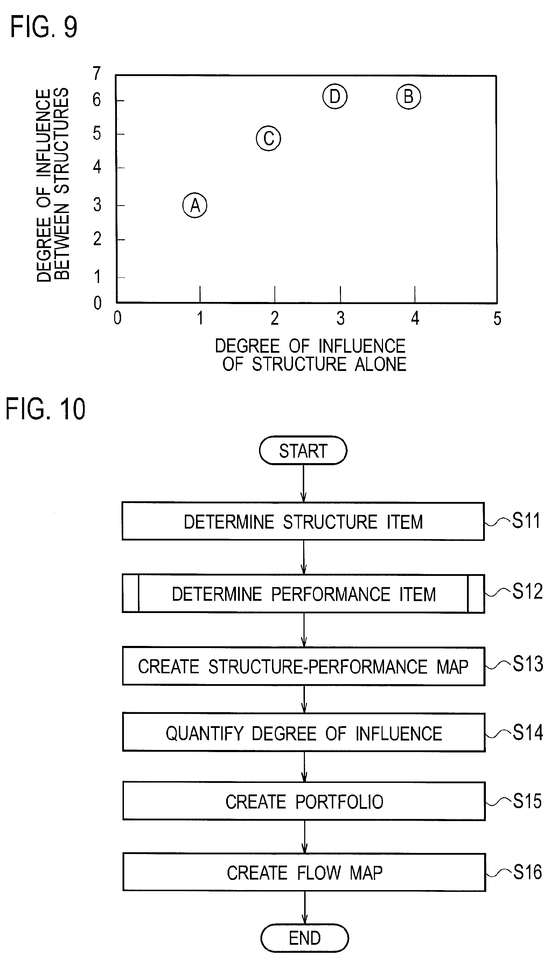

The portfolio creation means 16 is configured to create a portfolio by making a graph of the degrees of influence of the structure items quantified by the influence degree quantification means 15. As shown in Fig. 9, the portfolio creation means 16 creates a portfolio, for example, by plotting the degree of influence of the structure item alone and the degree of influence between the structure items shown in parts (a) and (b) of Fig. 8, which are quantified for each of the structure items A to D, on the horizontal axis and the vertical axis, respectively. In the portfolio, the closer the structure item to the upper right , the higher the degree of complexity, thereby indicating that careful attention should be paid to that item when it is considered. The portfolio is, for example, stored in the storage unit 2 and displayed on the display part of the output unit 4 or the like.

In the second embodiment of the present invention, the flow map creation means 14 rearranges the structure items in the performance-structure map based on the degrees of influence of the structure items quantified by the influence degree quantification means 15. For example, as shown in parts (a) and (b) of Fig. 8, the sum of the degree of influence of the structure item alone and the degree of influence between the structure items is 4, 10, 7, and 9 for the structure items A to D, respectively. The flow map creation means 14 then rearranges the structure items to B, D, C, and A in descending order of the sum. On the other hand, the order of the performance items is simply rearranged in descending or ascending order of the number of correlations present between the structure items and the performance item.

Meanwhile, the sum of the degree of influence of the structure item alone and the degree of influence between the structure items at the flow map creation means 14 is a mere example. The order of the structure items may be rearranged by individually evaluating the degree of influence of the structure item alone and the degree of influence between the structure items.

Moreover, like the first embodiment of the present invention, the flow map creation means 14 according to the second embodiment of the present invention may rearrange the order of the structure items in the performance-structure map in descending order of the number of correlations present between the structure item and the performance items and rearrange the order of the performance items in the performance-structure map in descending order of the number of correlations present between the structure items and the performance item.

Next, an example of a design assistance method according to the second embodiment of the present invention will be described with reference to a flowchart in Fig. 10.

(A) Steps S11 to S13 are substantially the same as those in the procedure in Fig. 5, and overlapping description will therefore be omitted. In step S14, the influence degree quantification means 15, for each structure item, quantifies the degree of influence of the structure item alone and the degree of influence between the structure items based on the correlations between the structure items and the performance items.

(B) In step S15, the portfolio creation means 16 creates a portfolio by making a graph of the degree of influence of the structure item alone and the degree of influence between the structure items quantified by the influence degree quantification means 15.

(C) In step S16, based on the structure items and the performance items in the performance-structure map, the flow map creation means 14 creates a flow map by rearranging the structure items in the performance-structure map in descending order of the sum of the degree of influence of the structure item alone and the degree of influence between the structure items quantified by the influence degree quantification means 15, and rearranging the order of the performance items in the performance-structure map in descending order of the number of correlations present between the structure items and the performance item.

According to the second embodiment of the present invention, the flow map is created automatically and logically by rearranging each of the order of the structure items and the order of the performance items in the performance-structure map based on the correlations between the structure items and the performance items. By presenting this flow map to the designers, the designers can easily figure out the efficient order of consideration that reduces the possibility of going back to a previous phase. Moreover, by having the designers consider the design items in the order of consideration provided by the flow map, differences in the order of consideration between the designers are eliminated, and the consideration can therefore be advanced uniformly. Hence, the efficiency of the work can be improved.

Also, the flow map creation means 14 rearranges the structure items in the performance-structure map in descending or ascending order of the number of correlations present between the structure item and the performance items and rearranges the performance items in the performance-structure map in descending or ascending order of the number of correlations present between the structure items and the performance item. In this way, the designers can easily figure out the efficient order of consideration that reduces the possibility of going back to a previous phase.

Also, the influence degree quantification means 15 quantifies the degrees of influence of the structure items based on the correlations between the structure items and the performance items, and the flow map creation means 14 rearranges the structure items in descending or ascending order of the degrees of influence of the structure items. In this way, the designers can easily figure out the efficient order of consideration with the degrees of influence of the structure items taken into account.

Also, the influence degree quantification means 15 quantifies the degrees of influence of the structure items based on the correlations between the structure items and the performance items, and the portfolio creation means 16 creates a portfolio by making a graph of the quantified degrees of influence of the structure items. In this way, the designers can easily quantitatively figure out which design items the designers should pay careful attention to when considering them.

Also, the influence degree quantification means 15 quantifies the degree of influence of the structure item alone and the degree of influence between the structure items. In this way, a portfolio and a flow map can be created with the degree of influence of the structure item alone and the degree of influence between the structure items taken into account.

[Third Embodiment]

In the description of the first and second embodiments of the present invention, when structure items and performance items are correlated with each other, the correlations are assumed to be equal in strength (degree of contribution). As a third embodiment of the present invention, a case will be described in which levels are taken into account for the strength (degree of contribution) of a correlation present between a structure item and a performance item.

For instance, for the DT system, levels can be set for the strength of a correlation present between a structure item and a performance item such that the structure items can be categorized, for example, in descending order of strength as: (A) a structure item that is an item which has a large degree of influence on the performance and with which the DT system design is intimately involved to achieve the performance; (B) a structure item which has an influence on the performance but with which the DT system design is not intimately involved to achieve the performance; and (C) a structure item which has a small influence on the performance.

The design assistance device according to the third embodiment of the present invention has the same configuration as the configuration shown in Fig. 7. The performance-structure map creation means 13 determines the strength of correlations present between structure items and performance items while setting levels for the strength, by using the design information stored in the design information storage section 26. Note that the presence or absence of a correlation between each structure item and each performance item and the strength of the correlation can instead be determined through the input unit 3.

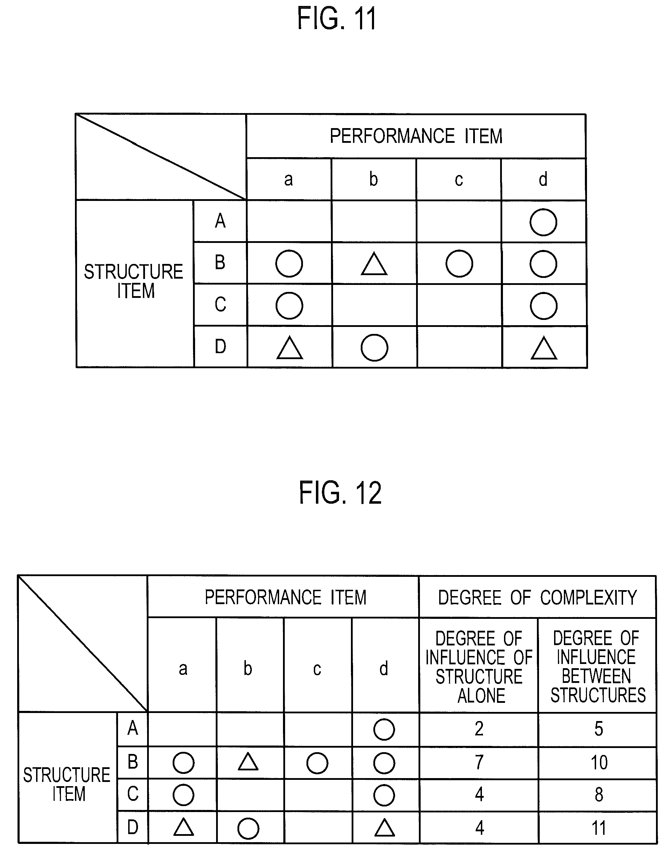

Further, the performance-structure map creation means 13 shows the strength of the correlations present between the structure items and the performance items by using multiple types of marks which correspond to the levels of the correlation strength. For example, in Fig. 11, two different levels are set for the correlation strength, and the stronger correlation is shown as "○" and the weaker correlation is shown as "Δ." The number of levels of the strength of a correction between a structure item and a performance item is not particularly limited, and three or more levels may be used.

The influence degree quantification means 15 quantifies the degree of influence of each of the structure items alone and the degree of influence between the structure items with the strength of the correlations between the structure items and the performance items taken into account. For example, as shown in Fig. 12, for each structure item, the degree of influence of the structure item alone is quantified by adding up the scores of the correlations in the raw direction, with a "○" mark equal to two points and a "Δ" mark equal to one point. For each structure item, the degree of influence between the structure items is quantified by adding up the scores of the different structure items that are correlated with common performance items, likewise with a "○" mark equal to two points and a "Δ" mark equal to one point.

Like the second embodiment of the present invention, the portfolio creation means 16 creates a portfolio by making a graph of the degrees of influence of the structure items quantified by the influence degree quantification means 15.

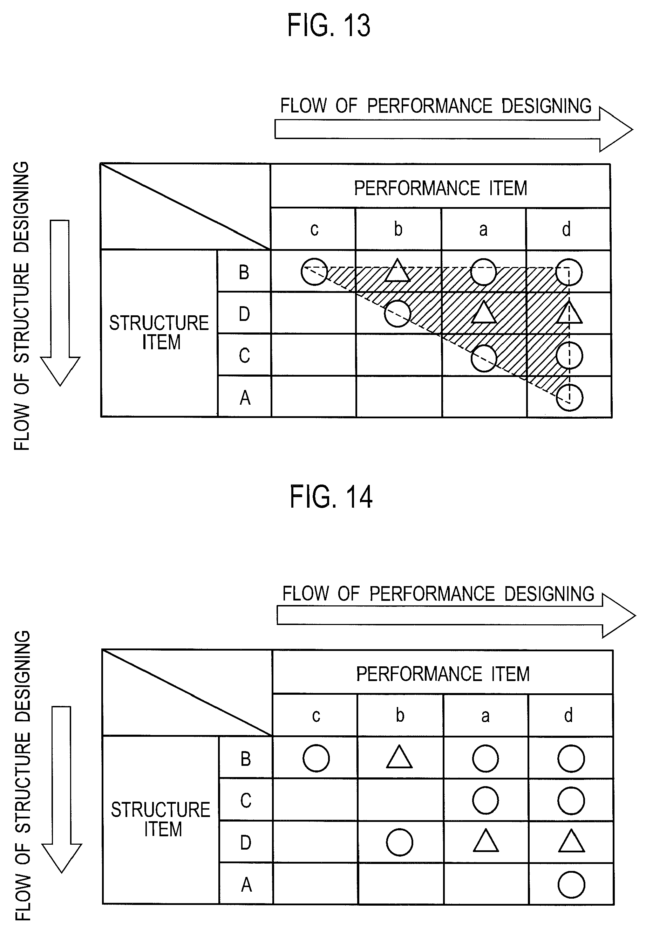

The flow map creation means 14 creates a flow map as shown in Fig. 13 by rearranging the structure items in the performance-structure map in descending order of the number of correlations present between the structure item and the performance items and rearranging the performance items in the performance-structure map in descending order of the number of correlations present between the structure items and the performance item. Here, the order of the structure items may be rearranged in descending order of the degrees of influence of the structure item quantified by the influence degree quantification means 15.

According to the third embodiment of the present invention, the flow map is created automatically and logically by rearranging each of the order of the structure items and the order of the performance items in the performance-structure map based on the correlations between the structure items and the performance items. By presenting this flow map to the designers, the designers can easily figure out the efficient order of consideration that reduces the possibility of going back to a previous phase. Moreover, by having the designers consider the design items in the order of consideration provided by the flow map, differences in the order of consideration between the designers are eliminated, and the consideration can therefore be advanced uniformly. Hence, the efficiency of the work can be improved.

Also, the flow map creation means 14 rearranges the structure items in the performance-structure map in descending or ascending order of the number of correlations present between the structure item and the performance items and rearranges the performance items in the performance-structure map in descending or ascending order of the number of correlations present between the structure items and the performance item. In this way, the designers can easily figure out the efficient order of consideration that reduces the possibility of going back to a previous phase.

Also, the influence degree quantification means 15 quantifies the degrees of influence of the structure items based on the correlations between the structure items and the performance items, and the flow map creation means 14 rearranges the structure items in descending or ascending order of the degrees of influence of the structure items. In this way, the designers can easily figure out the efficient order of consideration with the degrees of influence of the structure items taken into account.

Also, the influence degree quantification means 15 quantifies the degrees of influence of the structure items based on the correlations between the structure items and the performance items, and the portfolio creation means 16 creates a portfolio by making a graph of the quantified degrees of influence of the structure items. In this way, the designers can easily quantitatively figure out which design items the designers should pay careful attention to when considering them.

Also, the influence degree quantification means 15 quantifies the degree of influence of the structure item alone and the degree of influence between the structure items. In this way, a portfolio and a flow map can be created with the degree of influence of the structure item alone and the degree of influence between the structure items taken into account.

Also, the influence degree quantification means 15 quantifies the degrees of influence of each of the structure items in accordance with the strength of the correlations between the structure items and the performance items. In this way, a portfolio and a flow map can be created with the strength of the correlations between the structure items and the performance items taken into account.

[Other Embodiments]

Although the present invention has been described as above through the first to third embodiments, it should not be understood that the statement and the drawings constituting part of this disclosure limit this invention. Various alternative embodiments, examples, and operation techniques will become apparent to those skilled in the art from this disclosure.

For example, as design phases, there are multiple design phases such as a vehicle concept planning phase and a development phase and, in some cases, at each phase, design items for which specifications should be determined shift from a large item to a smaller and more detailed items. In such cases, the performance-structure map creation means 13 may create a performance-structure map at each of the multiple design phases. The performance-structure map at each design phase may be created using the structure items and the performance items involved in that design phase.

Also, although the description has been given by taking the DT system design as an example of the design to which the design assistance devices and the design assistance methods according to the embodiments of the present invention are applied, the design is not particularly limited to the DT system design. The design assistance devices and the design assistance methods according to the embodiments of the present invention are applicable to various designs such for example as the design of the entire vehicle and the design of a more detailed component than the DT system.

Also, in the case where there is a constraint condition on the rearrangement of the structure items and the performance items in the creation of a flow map, the rearrangement may be done by following the constraint condition. For example, in a case where there is a constraint condition that the structure items B and C in the flow map shown in Fig. 13 need to be considered together, the structure item C may be rearranged along with the structure item B, as shown in Fig. 14. Also, particular structure items and performance items may be rearranged with priority to high positions.

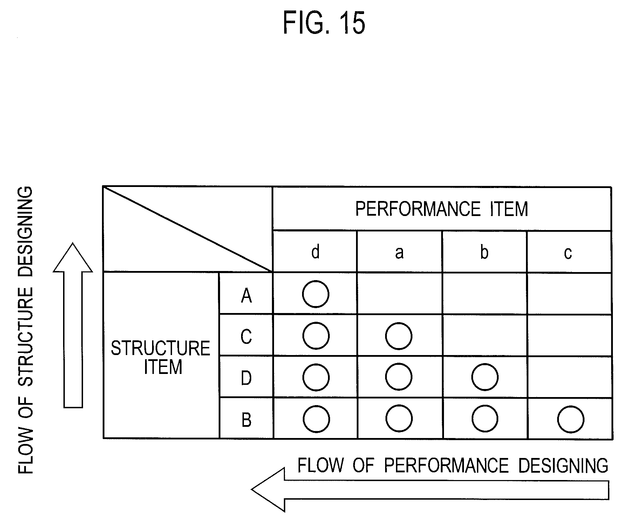

Also, although Fig. 4 has shown a flow map which is equivalent to an upper triangular matrix, a flow map which, for example, is equivalent to a lower triangular matrix as shown in Fig. 15 may instead be employed. In Fig. 15, the order of the structure items is rearranged in ascending order of the number of correlations present between the structure item and the performance items from top to bottom. On the other hand, the order of the performance items is rearranged in descending order of the number of correlations present between the structure items and the performance item from left to right. Even in this case, the design items can be considered efficiently by considering the structure items in the order of B, D, C, and A from bottom to top and, for each of these structure items, considering and determining the specifications of the performance items in the order of c, b, a, and d from right to left.

Alternatively, though not illustrated, when a flow map is created, the order of the structure items may be rearranged in ascending order of the number of correlations present between the structure item and the performance items from top to bottom, and the order of the performance items may be rearranged in ascending order of the number of correlations present between the structure items and the performance item from left to right.

Alternatively, though not illustrated, when a flow map is created, the order of the structure items may be rearranged in descending order of the number of correlations present between the structure item and the performance items from top to bottom, and the order of the performance items may be rearranged in descending order of the number of correlations present between the structure items and the performance item from left to right.

The entire content of Japanese Patent Application No. 2013-082900 (filed on April 11, 2013) is incorporated herein.

The content of the present invention has been described above through the embodiments of the present invention. It is, however, apparent to those skilled in the art that the present invention is not limited to this description and various changes and modifications can be made.

REFERENCE SIGNS LIST

| | |
|---|---|
| 1 | central processing unit (CPU) |
| 2 | storage unit |
| 3 | input unit |
| 4 | output unit |
| 11 | structure item determination means |
| 12 | performance item determination means |
| 13 | performance-structure map creation means |
| 14 | flow map creation means |
| 15 | influence quantification means |
| 16 | portfolio creation means |
| 21 | item information storage section |
| 22 | business requirement storage section |
| 23 | customer requirement storage section |
| 24 | target performance storage section |
| 25 | test information storage section |
| 26 | design information storing unit |

**Claims**

1. A design assistance device, comprising:

   structure item determination means for determining structure items related to a design object;
   performance item determination means for determining performance items related to the structure items;
   performance-structure map creation means for creating a performance-structure map in which correlations between the determined structure items and the determined performance items are shown in a matrix; and
   flow map creation means for creating a flow map by rearranging each of an order of the structure items and an order of the performance items in the performance-structure map based on the correlations between the structure items and the performance items.

2. The design assistance device according to claim 1, wherein the flow map creation means rearranges the structure items in the performance-structure map in descending order of the number of correlations present between the structure item and the performance items and rearranges the performance items in the performance-structure map in descending order of the number of correlations present between the structure items and the performance item.

3. The design assistance device according to claim 1, further comprising influence degree quantification means for quantifying a degree of influence of each of the structure items based on the correlations between the structure items and the performance items, wherein

   the flow map creation means rearranges the performance items in descending order of the number of correlations present between the structure items and the performance item, and rearranges the structure items in descending order of the degree of influence of the structure item.

4. The design assistance device according to claim 1 or 2, further comprising:

influence degree quantification means for quantifying a degree of influence of each of the structure items based on the correlations between the structure items and the performance items; and
portfolio creation means for creating a portfolio by making a graph of the quantified degree of influence of the structure item.

**5.** The design assistance device according to claim 3 or 4, wherein the influence degree quantification means quantifies a degree of influence of each of the structure items alone and a degree of influence between the structure items.

**6.** The design assistance device according to any one of claims 3 to 5, wherein the influence degree quantification means quantifies the degree of influence of each of the structure items in accordance with strength of the correlations between the structure items and the performance items.

**7.** A design assistance method, comprising the steps of:

determining structure items related to a design object;
determining performance items related to the structure items;
creating a performance-structure map in which correlations between the determined structure items and the determined performance items are shown in a matrix; and
creating a flow map by rearranging each of an order of the structure items and an order of the performance items in the performance-structure map based on the correlations between the structure items and the performance items.

# FIG. 1

2

1

CPU

| STRUCTURE ITEM DETERMINATION MEANS | ~11 |

| PERFORMANCE ITEM DETERMINATION MEANS | ~12 |

| PERFORMANCE-STRUCTURE MAP CREATION MEANS | ~13 |

| FLOW MAP CREATION MEANS | ~14 |

STORAGE UNIT

| ITEM INFORMATION STORAGE SECTION | ~21 |

| BUSINESS REQUIREMENT STORAGE SECTION | ~22 |

| CUSTOMER REQUIREMENT STORAGE SECTION | ~23 |

| TARGET PERFORMANCE STORAGE SECTION | ~24 |

| TEST INFORMATION STORAGE SECTION | ~25 |

| DESIGN INFORMATION STORAGE SECTION | ~26 |

| INPUT UNIT | ~3 |

| OUTPUT UNIT | ~4 |

**FIG. 2**

| | | | ENJOYMENT OF DRIVING | | ECOLOGY/ MILEAGE | | RELIABILITY | | QUIETNESS | |
|---|---|---|---|---|---|---|---|---|---|---|
| CUSTOMER AND BUSINESS REQUIREMENT → | | | | | | | | | | |
| PERFORMANCE REQUIREMENT → | | | DRIVING PERFORMANCE | | FUEL ECONOMY | | ROBUSTNESS | | NOISE | |
| PERFORMANCE ITEM → | | | ACCELER-ATION | ... | MODE | ... | COLLI-SION | ... | GEAR | ... |
| STRUCTURE ITEM | VEHICLE | VEHICLE MASS | O | | O | | O | | | O |
| | | ... | O | | O | | | | | |
| | ENGINE | MAXIMUM TORQUE | O | O | | | | | O | |
| | | ... | | | O | O | | | | O |
| | TRANSMISSION | GEAR RATIO | O | | O | | O | O | O | |
| | DRIVE SHAFT | JOINT SIZE | | | | | O | | | |
| | DIFFERENTIAL GEAR | SIZE | | | | | O | | | |
| | PROPELLER SHAFT | SIZE | | | | | O | | | O |

EP 2 985 709 A1

## FIG. 3

| | | PERFORMANCE ITEM | | | |
|---|---|---|---|---|---|
| | | a | b | c | d |
| STRUCTURE ITEM | A | | | | ◯ |
| | B | ◯ | ◯ | ◯ | ◯ |
| | C | ◯ | | | ◯ |
| | D | ◯ | ◯ | | ◯ |

## FIG. 4

FLOW OF PERFORMANCE DESIGNING →

FLOW OF STRUCTURE DESIGNING ↓

| | | PERFORMANCE ITEM | | | |
|---|---|---|---|---|---|
| | | c | b | a | d |
| STRUCTURE ITEM | B | ◯ | ◯ | ◯ | ◯ |
| | D | | ◯ | ◯ | ◯ |
| | C | | | ◯ | ◯ |
| | A | | | | ◯ |

# FIG. 5

START

DETERMINE STRUCTURE ITEM ∽S11

DETERMINE PERFORMANCE ITEM ∽S12

CREATE STRUCTURE-PERFORMANCE MAP ∽S13

CREATE FLOW MAP ∽S14

END

# FIG. 6

START

ACQUIRE BUSINESS REQUIREMENT ∽S21

EXTRACT CUSTOMER REQUIREMENT ∽S22

EXTRACT POWERTRAIN-DRIVETRAIN PERFORMANCE ∽S23

DETERMINE PERFORMANCE ITEM ∽S24

END

# FIG. 7

# FIG. 8

(a)

| | | PERFORMANCE ITEM | | | | DEGREE OF COMPLEXITY | |
| --- | --- | --- | --- | --- | --- | --- | --- |
| | | a | b | c | d | DEGREE OF INFLUENCE OF STRUCTURE ALONE | DEGREE OF INFLUENCE BETWEEN STRUCTURES |
| STRUCTURE ITEM | A | | | | ◯ | 1 | 3 |
| | B | ◯ | ◯ | ◯ | ◯ | 4 | 6 |
| | C | ◯ | | | ◯ | 2 | 5 |
| | D | ◯ | ◯ | | ◯ | 3 | 6 |

(b)

| | | PERFORMANCE ITEM | | | | DEGREE OF COMPLEXITY | |
| --- | --- | --- | --- | --- | --- | --- | --- |
| | | a | b | c | d | DEGREE OF INFLUENCE OF STRUCTURE ALONE | DEGREE OF INFLUENCE BETWEEN STRUCTURES |
| STRUCTURE ITEM | A | | | | ◯ | 1 | 3 |
| | B | ◯ | ◯ | ◯ | ◯ | 4 | 6 |
| | C | ◯ | | | ◯ | 2 | 5 |
| | D | ◯ | ◯ | | ◯ | 3 | 6 |

## FIG. 9

DEGREE OF INFLUENCE
OF STRUCTURE ALONE

(Y-axis) DEGREE OF INFLUENCE BETWEEN STRUCTURES

## FIG. 10

START

DETERMINE STRUCTURE ITEM — S11

DETERMINE PERFORMANCE ITEM — S12

CREATE STRUCTURE-PERFORMANCE MAP — S13

QUANTIFY DEGREE OF INFLUENCE — S14

CREATE PORTFOLIO — S15

CREATE FLOW MAP — S16

END

## FIG. 11

| | | | PERFORMANCE ITEM | | | |
|---|---|---|---|---|---|---|
| | | | a | b | c | d |
| STRUCTURE ITEM | | A | | | | ○ |
| | | B | ○ | △ | ○ | ○ |
| | | C | ○ | | | ○ |
| | | D | △ | ○ | | △ |

## FIG. 12

| | | | PERFORMANCE ITEM | | | | DEGREE OF COMPLEXITY | |
|---|---|---|---|---|---|---|---|---|
| | | | a | b | c | d | DEGREE OF INFLUENCE OF STRUCTURE ALONE | DEGREE OF INFLUENCE BETWEEN STRUCTURES |
| STRUCTURE ITEM | | A | | | | ○ | 2 | 5 |
| | | B | ○ | △ | ○ | ○ | 7 | 10 |
| | | C | ○ | | | ○ | 4 | 8 |
| | | D | △ | ○ | | △ | 4 | 11 |

## FIG. 13

FLOW OF PERFORMANCE DESIGNING

FLOW OF STRUCTURE DESIGNING

| | | PERFORMANCE ITEM | | | |
|---|---|---|---|---|---|
| | | c | b | a | d |
| STRUCTURE ITEM | B | ○ | △ | ○ | ○ |
| | D | | ○ | △ | △ |
| | C | | | ○ | ○ |
| | A | | | | ○ |

## FIG. 14

FLOW OF PERFORMANCE DESIGNING

FLOW OF STRUCTURE DESIGNING

| | | PERFORMANCE ITEM | | | |
|---|---|---|---|---|---|
| | | c | b | a | d |
| STRUCTURE ITEM | B | ○ | △ | ○ | ○ |
| | C | | | ○ | ○ |
| | D | | ○ | △ | △ |
| | A | | | | ○ |

# FIG. 15

| | | | PERFORMANCE ITEM | | | |
|---|---|---|:---:|:---:|:---:|:---:|
| | | | d | a | b | c |
| STRUCTURE ITEM | | A | ◯ | | | |
| | | C | ◯ | ◯ | | |
| | | D | ◯ | ◯ | ◯ | |
| | | B | ◯ | ◯ | ◯ | ◯ |

FLOW OF STRUCTURE DESIGNING

FLOW OF PERFORMANCE DESIGNING

## INTERNATIONAL SEARCH REPORT

| International application No. |
| --- |
| PCT/JP2014/060059 |

| A. CLASSIFICATION OF SUBJECT MATTER |
| --- |
| *G06F17/50*(2006.01)i, *G06Q50/04*(2012.01)i |

According to International Patent Classification (IPC) or to both national classification and IPC

| B. FIELDS SEARCHED |
| --- |
| Minimum documentation searched (classification system followed by classification symbols) |
| G06F17/50, G06Q50/04 |

| Documentation searched other than minimum documentation to the extent that such documents are included in the fields searched |
| --- |
| Jitsuyo Shinan Koho          1922–1996   Jitsuyo Shinan Toroku Koho   1996–2014 |
| Kokai Jitsuyo Shinan Koho   1971–2014   Toroku Jitsuyo Shinan Koho   1994–2014 |

| Electronic data base consulted during the international search (name of data base and, where practicable, search terms used) |
| --- |
| CiNii |

**C. DOCUMENTS CONSIDERED TO BE RELEVANT**

| Category* | Citation of document, with indication, where appropriate, of the relevant passages | Relevant to claim No. |
| --- | --- | --- |
| A | JP 2005-107773 A  (Hitachi, Ltd.), 21 April 2005 (21.04.2005), paragraphs [0042] to [0057] & US 2005/0071029 A1 | 1-7 |
| A | JP 2004-295210 A  (Toshiba Corp.), 21 October 2004 (21.10.2004), paragraphs [0023] to [0077] (Family: none) | 1-7 |
| A | US 7340409 B1  (Anthony W. ULWICK), 04 March 2008 (04.03.2008), columns 15 to 16 (Family: none) | 1-7 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 26 June, 2014 (26.06.14) | 08 July, 2014 (08.07.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**EP 2 985 709 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006011962 A
- JP 2013082900 A